# EUROPEAN PATENT SPECIFICATION

(11) **EP 3 996 148 B1**
(45) Date of publication and mention of the grant of the patent: **14.10.2026**
(21) Application number: 21205785.5
(22) Date of filing: 01.11.2021
(51) Int. Cl.: H10D 30/69, H10D 64/01, H10D 64/66, H10D 64/68, H10D 30/60, H10B 51/30, H10B 53/30, H10D 30/43, H10D 30/62, H10D 30/67, H10D 84/01, H10D 84/03, H10D 84/83

(54) **SEMICONDUCTOR DEVICE AND SEMICONDUCTOR APPARATUS INCLUDING THE SAME**
HALBLEITERBAUELEMENT UND HALBLEITERVORRICHTUNG DAMIT
DISPOSITIF À SEMICONDUCTEUR ET APPAREIL À SEMICONDUCTEUR LE COMPRENANT

(30) Priority: 04.11.2020 KR 20200146373; 29.12.2020 KR 20200186785
(43) Date of publication of application: 11.05.2022
(73) Proprietor: Samsung Electronics Co., Ltd., Suwon-si, Gyeonggi-do 16677 (KR)
(72) Inventor: Heo, Jinseong, 16678, Gyeonggi-do, (KR); Lee, Yunseong, 16678, Gyeonggi-do, (KR); Nam, Seunggeol, 16678, Gyeonggi-do, (KR); Bae, Hagyoul, 16678, Gyeonggi-do, (KR); Moon, Taehwan, 16678, Gyeonggi-do, (KR); Jo, Sanghyun, 16678, Gyeonggi-do, (KR)
(74) Representative: Elkington and Fife LLP

(56) References cited:
- US-A1- 2017 358 684
- US-A1- 2019 131 407
- US-A1- 2020 006 547
- HAGGERTY RYAN P. ET AL: "Thermal Expansion of HfO 2 and ZrO 2 : Thermal Expansion", vol. 97, no. 7, 1 July 2014 (2014-07-01), US, pages 2213 - 2222, XP055892972, ISSN: 0002-7820, Retrieved from the Internet <URL:https://api.wiley.com/onlinelibrary/tdm/v1/articles/10.1111%2Fjace.12975> DOI: 10.1111/jace.12975
- WANG XINGQI ET AL: "Calculation of Thermal Expansion Coefficient of Rare Earth Zirconate System at High Temperature by First Principles", MATERIALS, vol. 15, no. 6, 18 March 2022 (2022-03-18), pages 2264, XP055922405, DOI: 10.3390/ma15062264
- CEN Z H ET AL: "Temperature effect on titanium nitride nanometer thin film in air", JOURNAL OF PHYSICS D: APPLIED PHYSICS, INSTITUTE OF PHYSICS PUBLISHING, BRISTOL, GB, vol. 50, no. 7, 23 January 2017 (2017-01-23), pages 75105, XP020313406, ISSN: 0022-3727, [retrieved on 20170123], DOI: 10.1088/1361-6463/AA54E6
- LAHAV A ET AL: "MEASUREMENT OF THERMAL EXPANSION COEFFICIENTS OF W, WSI, WN, AND WSIN THIN FILM METALLIZATONS", JOURNAL OF APPLIED PHYSICS, AMERICAN INSTITUTE OF PHYSICS, 2 HUNTINGTON QUADRANGLE, MELVILLE, NY 11747, vol. 67, no. 2, 15 January 1990 (1990-01-15), pages 734 - 738, XP000560582, ISSN: 0021-8979, DOI: 10.1063/1.345779

## Description

### FIELD OF THE INVENTION

Some example embodiments relate to a semiconductor device and/or a semiconductor apparatus including the semiconductor device.

### BACKGROUND OF THE INVENTION

Ferroelectrics refer to materials having ferroelectricity capable of maintaining a spontaneous polarization by aligning internal electric dipole moments even when an external electric field is not applied to the materials. For example, ferroelectrics have a semi-permanent polarization (or electric field) even when a voltage applied thereto is reduced to 0 V. Research has been conducted into improving the performance of semiconductor devices by applying or incorporating such ferroelectric properties to the semiconductor devices. For example, studies have been conducted from the past to apply ferroelectrics, of which the polarization exhibits hysteresis with respect to voltage, to semiconductor devices.

Furthermore, recently published studies show that ferroelectrics may have negative capacitance in a specific region, and when this characteristic is applied to a transistor, the subthreshold swing of the transistor may be reduced to about 60 mV/dec or less, which may be the theoretical limit of existing silicon-based transistors. For this reason, studies are ongoing to use ferroelectrics in low-power semiconductor devices.

In addition, since hafnium-based oxides have ferroelectricity, studies have been conducted to use hafnium-based oxides in semiconductor devices. Hafnium-based oxides are expected to be useful for miniaturization of semiconductor devices because hafnium-based oxides are friendly, e.g. are easily incorporated, into semiconductor processes. Hafnium-based oxides also have ferroelectricity even when being formed as a very thin film having a thickness of several nanometers (nm) or smaller.

United States patent application US 2020/006547 A1 discloses a semiconductor device with a dielectric layer disposed over a portion of the substrate, and a diffusion blocking layer disposed over the dielectric layer. The diffusion blocking layer and the dielectric layer have different material compositions. The semiconductor device includes a ferroelectric layer disposed over the diffusion blocking layer.

### SUMMARY OF THE INVENTION

Provided are ferroelectric semiconductor devices having a multilayer electrode structure.

Alternatively or additionally, provided are ferroelectric semiconductor devices having low current leakage and high permittivity.

Alternatively or additionally, provided are semiconductor apparatuses having various threshold voltages.

Additional aspects will be set forth in part in the description which follows and, in part, will be apparent from the description, and/or may be learned by practice of some example embodiments.

There is provided a semiconductor device according to claim 1.

The difference between the thermal expansion coefficients of the second electrode layer and the ferroelectric layer is greater than the difference between the thermal expansion coefficients of the first electrode layer and the ferroelectric layer. For example, the difference between the thermal expansion coefficients of the second electrode layer and the ferroelectric layer may range from about 3.0x10⁻⁶/K to about 10.0x10⁻⁶/K, and the difference between the thermal expansion coefficients of the first electrode layer and the ferroelectric layer may be greater than about 0.0/K but may be equal to or less than about 3.0x10⁻⁶/K.

The second electrode layer has a greater thickness than the first electrode layer. For example, the thickness of the second electrode layer may range from about 1.0 times to about 30.0 times the thickness of the first electrode layer. The first electrode layer may include TiN, and the second electrode layer may include molybdenum (Mo). The second electrode layer may not include TiN.

The ferroelectric layer may include a material represented by MO₂ (where M refers to hafnium (Hf), zirconium (Zr), or a combination thereof). Alternatively or additionally, the ferroelectric layer may further include at least one dopant material selected from the group consisting of lutetium (Lu), yttrium (Y), lanthanum (La), barium (Ba), and strontium (Sr), or may further include at least one dopant material selected from the group consisting of aluminum (Al), titanium (Ti), tantalum (Ta), scandium (Sc), and magnesium (Mg).

According to some example embodiments, a semiconductor apparatus may include at least one semiconductor device including the aforementioned ferroelectric layer. For example, the semiconductor apparatus may include at least two semiconductor devices, for example two semiconductor devices of the same conductivity type, oxide thickness, etc., having different threshold voltages Vth. For example, the at least two semiconductor devices may be different from each other in the compositions and thicknesses of first electrode layers thereof; the compositions and thicknesses of second electrode layers thereof; and/or the compositions and thicknesses of ferroelectric layers thereof. Other electrical characteristics of the at least two semiconductor devices such as implant characteristics and/or channel properties may otherwise be the same or similar; however, example embodiments are not limited thereto.

### BRIEF DESCRIPTION OF THE DRAWINGS

The above and other aspects, features, and/or advantages of certain embodiments of the disclosure will be more apparent from the following description taken in conjunction with the accompanying drawings, in which:
FIGS. 1 to 3 are views schematically illustrating semiconductor devices (field effect transistors (FETs)) according to some example embodiments;
FIGS. 4A and 4B are views schematically illustrating a semiconductor device (FET) according to some example embodiments;
FIGS. 5A and 5B are views schematically illustrating a semiconductor device (FET) according to some example embodiments;
FIG. 6 is a view schematically illustrating a semiconductor device (capacitor) according to some example embodiments;
FIG. 7 is a view schematically illustrating a semiconductor apparatus according to some example embodiments;
FIG. 8 is a view schematically illustrating a semiconductor apparatus (having a structure in which a capacitor and an FET are connected to each other) according to some example embodiments;
FIGS. 9 and 10 are conceptual views schematically illustrating device architectures applicable to electronic devices according to embodiments; and
FIG. 11 is a view schematically illustrating a semiconductor apparatus according to some example embodiments.

### DETAILED DESCRIPTION OF SOME EXAMPLE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

In the following description, terms are used only for explaining specific embodiments while not limiting the scope of the present disclosure. When an element is referred to as being "above" or "on" another element, the element may be directly on an upper, lower, left, or right side of the other element while making contact with the other element or may be above an upper, lower, left, or right side of the other element without making contact with the other element.

The terms of a singular form may include plural forms unless otherwise mentioned. Unless otherwise mentioned, the terms "comprises" and/or "comprising" used herein specify the presence of stated features, numbers, steps, processes, elements, components, materials, or combinations thereof but do not preclude the presence or addition of one or more other features, numbers, steps, processes, elements, components, materials, or combinations thereof.

Although terms such as "first," "second," and "third" are used to describe various elements, the terms are only used to distinguish one element from other elements, and the features of the elements such as order and type should not be limited by the terms. In addition, terms such as "unit," "means," "module," or "part" may be used to denote a unit of a comprehensive structure that has at least one function or operation and is implemented with hardware, software, or a combination of hardware and software.

Hereinafter, some example embodiments will be described with reference to the accompanying drawings. In the drawings, like reference numerals refer to like elements, and the sizes of elements (such as the widths and thicknesses of layers or regions) may be exaggerated for clarity of illustration. Example embodiments described herein are for illustrative purposes only, and various modifications may be made therein.

An aspect may provide a semiconductor device including a ferroelectric layer and a semiconductor apparatus including the semiconductor device. The semiconductor device may be or may include a memory device and/or a non-memory device such as a field effect transistor (FET), a capacitor, another active and/or passive electrical component, or a combination thereof, but is not limited thereto. The semiconductor apparatus may include a plurality of semiconductor devices and may be used in various electronic devices. Therefore, the electronic devices may have improved characteristics in terms of at least one of efficiency, operational speed, and power consumption compared with electronic devices of the related art.

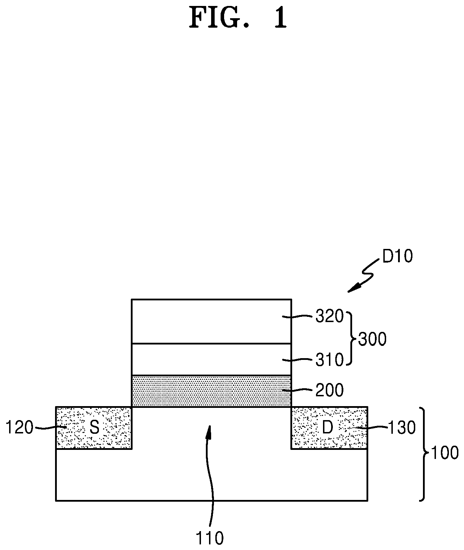

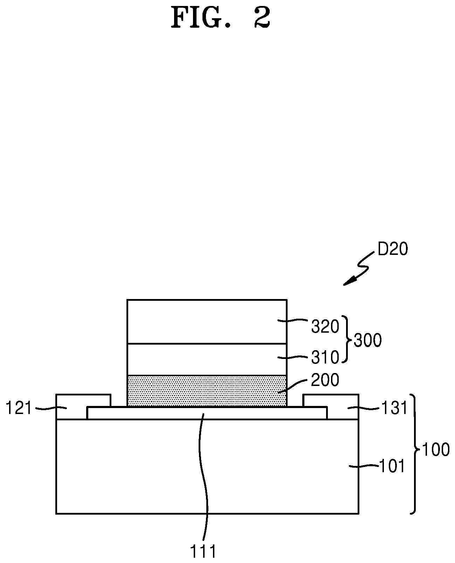

FIGS. 1 and 2 are views schematically illustrating FETs D10 and D20 according to some example embodiments. Referring to FIGS. 1 and 2, each of the FETs D10 and D20 includes a substrate 100 including a source 120 or 121 and a drain 130 or 131, a gate electrode 300 arranged above the substrate 100, and a ferroelectric layer 200 arranged between the substrate 100 and the gate electrode 300. Each of the FETs D10 and D20 may be a logic switching device. The logic switching device is a concept contrasted with a memory device (memory transistor) and may have non-memory characteristics. The logic switching device may be a non-memory ON/OFF switching device; however, example embodiments are not limited thereto.

The substrate 100 may include a semiconductor material. For example, the substrate 100 may include silicon (Si), germanium (Ge), SiGe, a Group III-V semiconductor, or the like, and may be modified and used in various forms such as a silicon on insulator (SOI). The substrate 100 may be a single-crystal material, and may be lightly doped with impurities; however, example embodiments are not limited thereto.

The substrate 100 including the source 120 or 121 and the drain 130 or 131 may include a channel 110 or 111 which is electrically connected to the source 120 or 121 and the drain 130 or 131. The source 120 or 121 may be electrically connected to, e.g. be in contact with an end of the channel 110 or 111, and the drain 130 or 131 may be electrically connected to, e.g. be in contact with the other end of the channel 110 or 111.

Referring to FIG. 1, the channel 110 may be defined as a region of the substrate 100 between the source 120 and the drain 130. The source 120 and the drain 130 may be formed by doping different regions of the substrate 100 with a dopant such as at least one of boron, phosphorus, or arsenic, and in this case, the source 120, the channel 110, and the drain 130 may include a substrate material as a base material.

There may be a high concentration of impurities of a first conductivity type in the source 120 and in the drain 130, and there may be a lower concentration of impurities of the second conductivity type in the channel 110; however, example embodiments are not limited thereto.

Alternatively or additionally, referring to FIG. 2, the channel 111 may be provided as a material layer (e.g. a thin film) separate from a substrate region 101. The material composition of the channel 111 may vary. For example, the channel 111 may include a semiconductor material such as silicon (Si), germanium (Ge), SiGe, a Group III-V semiconductor, and/or may include at least one selected from the group including or consisting of an oxide semiconductor, a nitride semiconductor, an oxynitride semiconductor, a two-dimensional (2D) material, quantum dots, and an organic semiconductor. For example, the oxide semiconductor may include InGaZnO or the like, the 2D material may include a transition metal dichalcogenide (TMD) and/or graphene, and the quantum dots may include colloidal quantum dots and/or nanocrystals. Alternatively or additionally, the source 121 and the drain 131 may include a conductive material, and for example, the source 121 and the drain 131 may each independently include at least one of a metal, a metal compound, or a conductive polymer.

The gate electrode 300 may be arranged above the substrate 100 and may be apart from the substrate 100 while facing the channel 110 or 111.

The ferroelectric layer 200 may be arranged on the channel 110 or 111 between the substrate 100 and the gate electrode 300. The ferroelectric layer 200 may form a gate stack together with the gate electrode 300.

As described above, ferroelectrics may have negative capacitance in a specific operation region, and thus when a ferroelectric is used in a gate stack, e.g. operates as a dielectric, of an FET, the subthreshold swing of the FET may be lowered.

Such an FET is manufactured by forming, on the substrate 100, an amorphous layer having the same composition as that of the ferroelectric layer 200, forming the gate electrode 300 on the amorphous layer, and annealing, e.g. laser annealing and/or furnace annealing and/or annealing with a fast thermal process (FTP), the amorphous layer and the gate electrode 300. During the annealing, tensile stress occurs between the amorphous layer and the gate electrode 300 as the amorphous layer is crystallized as a crystalized layer, and thus the ferroelectricity of the crystallized layer may be increased.

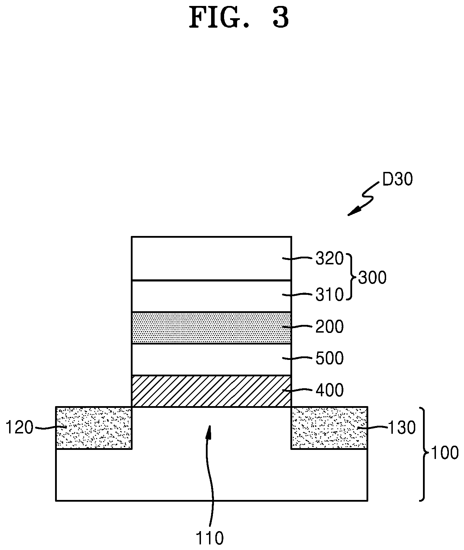

In addition, recent electronic devices may require or use semiconductor apparatuses each having various threshold voltages Vth for various applications, and yet having similar or the same other properties such as implant profiles and/or dimensionality. For example, in a plurality of semiconductor devices included in a semiconductor apparatus at least two of the plurality of semiconductor devices, are required to have or are intended to have different threshold voltages Vth instead of having the same threshold voltage Vth. The threshold voltage Vth of each of the FETs (semiconductor devices) D10 and D20 may be dependent on factors such as the composition of the ferroelectric layer 200, the work function of the gate electrode 300, the dimensions of the channel 110, the properties and dimensions of the source 120 and/or the drain 130, and the compositions of other components (for example, a dielectric layer 400 shown in FIG. 3).

According to some example embodiments, the gate electrode 300 may have a structure for increasing the ferroelectricity of the ferroelectric layer 200 and obtaining an intended threshold voltage Vth. For example, the gate electrode 300 of each of the FETs (ferroelectric semiconductor devices) D10 and D20 may include a first electrode layer 310 and a second electrode layer 320 which have different coefficients of thermal expansion (CTEs)/thermal expansion coefficients and/or different thicknesses.

The first electrode layer 310 and the second electrode layer 320 may have thermal expansion coefficients less than the thermal expansion coefficient of the ferroelectric layer 200. The difference in thermal expansion coefficient may increase tensile stress in an amorphous layer during a fabrication process of the FET (semiconductor device) D10 or D20, and thus the ferroelectricity of the ferroelectric layer 200 may increase.

Alternatively or additionally, the first electrode layer 310 arranged adjacent to the ferroelectric layer 200 may include a material having a work function corresponding to the threshold voltage Vth of the FET (semiconductor device) D10 or D20.

The first electrode layer 310 and the second electrode layer 320 may be arranged such that the thermal expansion coefficients of the first electrode layer 310 and the second electrode layer 320 may be more different from that of the ferroelectric layer 200 as the distance from the ferroelectric layer 200 increases. For example, the difference between the thermal expansion coefficient of the second electrode layer 320 and the thermal expansion coefficient of the ferroelectric layer 200 may be greater than the difference between the thermal expansion coefficient of the first electrode layer 310 and the thermal expansion coefficient of the ferroelectric layer 200. Alternatively or additionally, the thicknesses of the first electrode layer 310 and the second electrode layer 320 may increase as the distance from the ferroelectric layer 200 increases. For example, the thickness of the second electrode layer 320 may be greater than the thickness of the first electrode layer 310. The gate electrode 300 may realize/effect an intended threshold voltage Vth from a difference in work function on the surface of the ferroelectric layer 200, and may improve ferroelectricity of the ferroelectric layer 200 by increasing tensile stress applied to the entirety of the ferroelectric layer 200.

For example, the difference between the thermal expansion coefficient of the second electrode layer 320 and the thermal expansion coefficient of the ferroelectric layer 200 may be about 3.0x10⁻⁶/K or more, about 3.1x10⁻⁶/K or more, about 3.2x10⁻⁶/K or more, about 3.5x10⁻⁶/K or more, about 4.0x10⁻⁶/K or more, about 4.5x10⁻⁶/K or more, about 5.0x10⁻⁶/K or more, about 5.5x10⁻⁶/K or more, about 6.0x10⁻⁶/K or more, about 10.0x10⁻⁶/K or less, about 9.5x10⁻⁶/K or less, about 9.0x10⁻⁶/K or less, about 8.5x10⁻⁶/K or less, about 8.0x10⁻⁶/K or less, about 7.7x10⁻⁶/K or less, or about 7.5x10⁻⁶/K or less I can. The difference between the thermal expansion coefficient of the first electrode layer 310 and the ferroelectric layer 200 may be: greater than about 0.0/K; about 0.5x10⁻⁶/K or more; about 1.0x10⁻⁶/K or more; about 1.5x10⁻⁶/K or more; about 2.0x10⁻⁶/K or more; about 3.0x10⁻⁶/K or less; less than about 3.0x10⁻⁶/K ; about 2.9x10⁻⁶/K or less; or about 2.8x10⁻⁶/K or less. Each of the first electrode layer 310 and the second electrode layer 320 may have a thermal expansion coefficient of greater than about 0.0/K but equal to or less than about 12.0x10⁻⁶/K. The thermal expansion coefficient of the second electrode layer 320 may be about 9.0x10⁻⁶/K or less, about 8.5x10⁻⁶/K or less, about 8.0x10⁻⁶/K or less, about 7.5.0x10⁻⁶/K or less, about 7.0x10⁻⁶/K or less, about 6.5x10⁻⁶/K or less, about 6.0x10⁻⁶/K or less, about 5.5x10⁻⁶/K or less, or about 5.0x10⁻⁶/K or less. The thermal expansion coefficient of the first electrode layer 310 may be: less than about 12.0x10⁻⁶/K; about 11.0x10⁻⁶/K or less; about 10.0x10⁻⁶/K or less; about 9.8x10⁻⁶/K or less; about 9.6x10⁻⁶/K or less; about 6.0x10⁻⁶/K or more; about 6.3x10⁻⁶/K or more; about 6.5x10⁻⁶/K or more; about 7.0x10⁻⁶/K or more; or about 7.5x10⁻⁶/K or more. As used herein, "difference" may refer to a positive or negative difference, or alternatively may refer to an absolute value of a difference.

Alternatively or additionally, the thickness of the second electrode layer 320 may be about 1.0 times or more, about 1.5 times or more, about 2.0 times or more, about 2.5 times or more, about 3.0 times or more, about 5.0 times or more, about 7.0 times or more, about 10.0 times or more about 30.0 times or less, about 27.0 times or less, about 25.0 times or less, about 23.0 times or less, or about 20.0 times or less the thickness of the first electrode layer 310. The second electrode layer 320 may have a thickness of about 10 nm or more, about 15 nm or more, about 20 nm or more, about 25 nm or more, about 30 nm or more, about 35 nm or more, about 200 nm or less, about 170 nm or less, about 160 nm or less, about 150 nm or less, about 140 nm or less, about 130 nm or less, about 120 nm or less, about 110 nm or less, or about 100 nm or less. The first electrode layer 310 may have a thickness of about 1.0 nm or more, about 1.5 nm or more, about 2.0 nm or more, about 2.5 nm or more, about 3.0 nm or more, about 10.0 nm or less, about 9.0 nm or less, about 8.0 nm or less, or about 7.0 nm or less.

The first electrode layer 310 and the second electrode layer 320 have different compositions and may each independently include at least one selected from the group including or consisting of platinum (Pt), niobium (Nb), ruthenium (Ru), molybdenum (Mo), tungsten (W), and TiN. For example, the first electrode layer 310 may include TiN and may not include molybdenum, and the second electrode layer 320 may include molybdenum (Mo) and may not include TiN.

Referring back to FIGS. 1 and 2, the ferroelectric layer 200 may include a material represented by MO₂ (where M refers to hafnium (Hf), zirconium (Zr), or a combination thereof). The material (metal oxide) may have ferroelectricity even when being formed as a very thin film having a thickness of several nanometers (nm), and may enable/guarantee high mass or high volume productivity because the material is applicable to manufacturing processes of silicon-based semiconductor devices of the related art. For example, the ferroelectric layer 200 having a material of MO₂ with M being either or both of Hf and Zr may be formed in the FET D10 with the same or similar tools or equipment as in related devices that do not include the ferroelectric layer 200.

Alternatively or additionally, the ferroelectric layer 200 may have an orthorhombic crystal phase. For example, the ferroelectric layer 200 may include various crystal phases such as an orthorhombic crystal phase and a tetragonal crystal phase, but may include the orthorhombic crystal phase as a dominant phase or a phase having the largest fraction or fraction by volume.

The ferroelectric layer 200 may be distinguished from a high-k dielectric material or the like according to at least one of the presence and/or size of residual polarization, the composition of a metal oxide, the type and content of a dopant, the crystal phase, and the like of the ferroelectric layer 200. The type and content of each element in the ferroelectric layer 200 may be measured by a method such as at least one of X-ray photoelectron spectroscopy (XPS), Auger electron spectroscopy (AES), or inductively coupled plasma (ICP). Alternatively or additionally, the distribution of crystal phases in the ferroelectric layer 200 may be measured by a method such as transmission electron microscopy (TEM) or grazing incidence X-ray diffraction (GIXRD).

The ferroelectric layer 200 may include a base material represented by MO₂ (where M refers to Hf, Zr or a combination thereof), and at least one dopant material selected from the group including or consisting of carbon (C), silicon (Si), germanium (Ge), tin (Sn), lead (Pb), aluminum (Al), yttrium (Y), lanthanum (La), gadolinium (Gd), magnesium (Mg), calcium (Ca), strontium (Sr), barium (Ba), titanium (Ti), scandium (Sc), tantalum (Ta), and lutetium (Lu). The dopant material may be included in an amount of: greater than about 0 at%; about 0.2 at% or more; about 0.5 at% or more; about 1 at% or more; about 2 at% or more; about 3 at% or more; about 20 at% or less; about 15 at% or less; about 12 at% or less; about 10 at % Or less; about 8 at% or less; about 7 at% or less; or about 6 at% or less, based on the metal element amount in the base material.

Alternatively or additionally, the type and/or content of the dopant material of the ferroelectric layer 200 may be controlled to adjust the threshold voltage Vth of the FET (semiconductor device) D10 or D20. For example, to lower the threshold voltage Vth of the semiconductor device, e.g. to lower in absolute value, the ferroelectric layer 200 may further include at least one dopant material selected from the group including or consisting of aluminum (Al), titanium (Ti), tantalum (Ta), scandium (Sc), and magnesium (Mg), or to increase the threshold voltage Vth of the semiconductor device, the ferroelectric layer 200 may further include at least one dopant material selected from the group including or consisting of lutetium (Lu), yttrium (Y), lanthanum (La), barium (Ba), and strontium (Sr).

The ferroelectric layer 200 may have a thickness of greater than about 0 nm but less than or equal to about 20 nm. For example, the thickness of the ferroelectric layer 200 may be: greater than about 0 nm; about 0.1 nm or more; about 0.2 nm or more; about 0.3 nm or more; about 0.4 nm or more; about 0.5 nm or more; about 0.6 nm or more; about 0.7 nm or more; about 0.8 nm or more; about 1.0 nm or more; about 1.5 nm or more; about 20 nm or less; about 18 nm or less; about 15 nm or less; about 12 nm or less; about 10 nm or less; about 8 nm or less; about 6 nm or less; about 5 nm or less; about 4 nm or less; about 3 nm or less; about 2 nm or less; or about 1 nm or less. The thickness of the ferroelectric layer 200 may be measured using, for example, an ellipsometer (such as, but not limited to, an SE MG-1000 by Nano View) or the like.

FIG. 3 is a view schematically illustrating a semiconductor device (FET) D30 according to another embodiment. Referring to FIG. 3, a dielectric layer 400 may be further included between a channel 110 and a ferroelectric layer 200. The dielectric layer 400 may suppress and/or prevent electrical leakage. The thickness of the dielectric layer 400 may be about 0.1 nm or more, about 0.3 nm or more, about 0.5 nm or more, about 5 nm or less, about 4 nm or less, about 3 nm or less, about 2 nm or less, or about 1 nm or less. The dielectric layer 400 may include a paraelectric material and/or a high-k dielectric material, such as at least one of silicon oxide, silicon nitride, aluminum oxide, hafnium oxide, zirconium oxide, or a 2D insulator such as hexagonal boron nitride (h-BN). For example, the dielectric layer 400 may include silicon oxide (SiO₂), silicon nitride (SiNₓ), or the like. Alternatively or additionally, the dielectric layer 400 may include hafnium oxide (HfO₂), hafnium silicon oxide (HfSiO₄), lanthanum oxide (La₂O₃), lanthanum aluminum oxide (LaAlO₃), zirconium oxide (ZrO₂), zirconium silicon oxide (ZrSiO₄), tantalum oxide (Ta₂O₅), titanium oxide (TiO₂), strontium titanium oxide (SrTiO₃), yttrium oxide (Y₂O₃), aluminum oxide (Al₂O₃), lead scandium tantalum oxide (PbSc_{0.5}Ta_{0.5}O₃), lead zinc niobate (PbZnNbO₃), or the like. Alternatively, the dielectric layer 400 may include: a metal nitride oxide such as aluminum oxynitride (AlON), zirconium oxynitride (ZrON), hafnium oxynitride (HfON), lanthanum oxynitride (LaON), or yttrium oxynitride (YON); a silicate such as ZrSiON, HfSiON, YSiON, or LaSiON; or an aluminate such as ZrAlON or HfAlON.

Referring to FIG. 3, a conductive layer 500 may be further included between the channel 110 and the ferroelectric layer 200. The conductive layer 500 may have a conductivity of about 1 Mohm/square or less. The conductive layer 500 may be a floating electrode and may include a metal or a metal compound.

FETs may be implemented in various forms such as a 2D form and/or a 3D form. For example, FETs may be provided in the form of a 1-gate on channel such as a planar-FET, a 3-gate on channel such as a Fin-FET, or a 4-gate on channel such as a gate-all-around-FET.

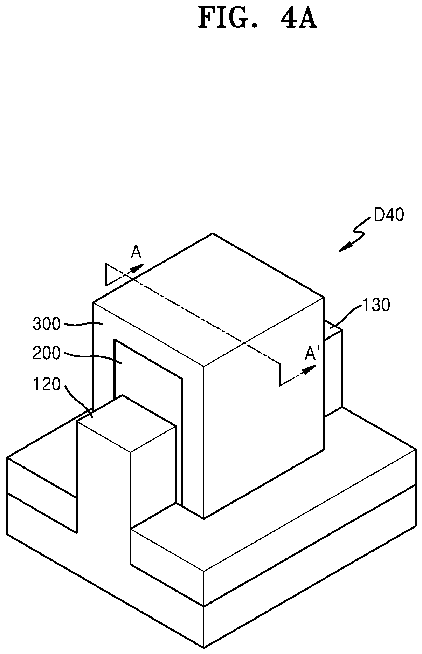

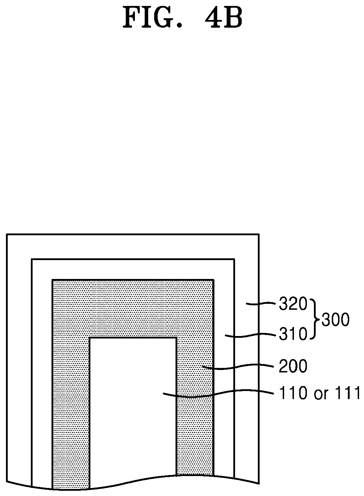

FIG. 4A is a view schematically illustrating a semiconductor device, e.g., a Fin-FET D40, according to some example embodiments, and FIG. 4B is a cross-sectional view taken along line A-A' of FIG. 4A. Referring to FIGS. 4A and 4B, the Fin-FET D40 may include a source 120, a drain 130, and a channel 110 or 111 defined as a region between the source 120 and the drain 130, and the channel 110 or 111 may have a fin shape. A gate electrode 300 may be arranged on a substrate having a fin shape to cross the fin shape, and first and second electrode layers 310 and 320 of the gate electrode 300 may be arranged on the channel 110 or 111 to sequentially surround the channel 110 or 111.

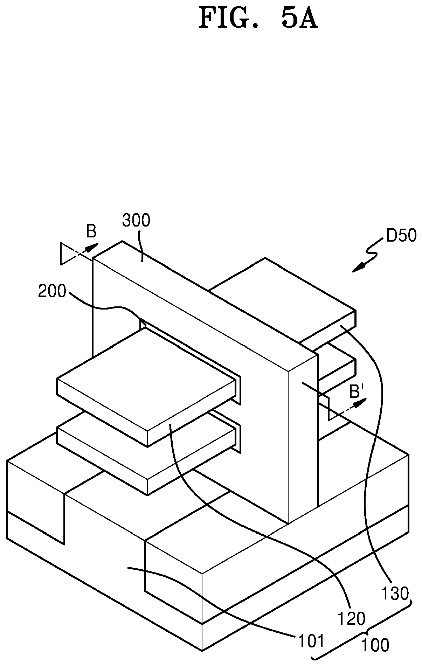

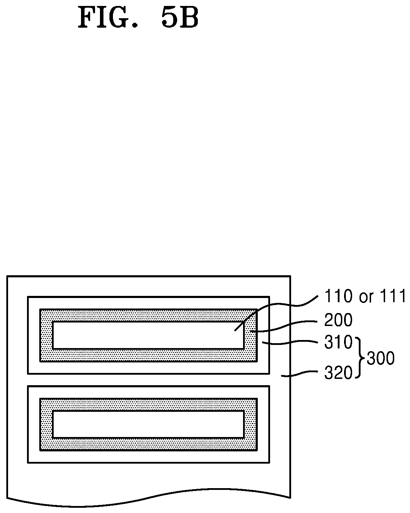

FIG. 5A is a view schematically illustrating a semiconductor device, for example, a gate-all-around-FET D50, according to some example embodiments, and FIG. 5B is a cross-sectional view taken along line B-B' of FIG. 5A. Referring to FIGS. 5A and 5B, the gate-all-around-FET D50 may include source 120, a drain 130, and a channel 110 or 111 defined as a region between the source 120 and the drain 130, and the channel 110 or 111 may have a wire or sheet shape. The source 120, the drain 130, and the channel 110 or 111 may be apart from a substrate region 101. A gate electrode 300 may cross the source 120, the drain 130, and the channel 110 or 111, and first and second electrode layers 310 and 320 of the gate electrode 300 may be arranged on the channel 110 or 111 to sequentially surround the channel 110 or 111.

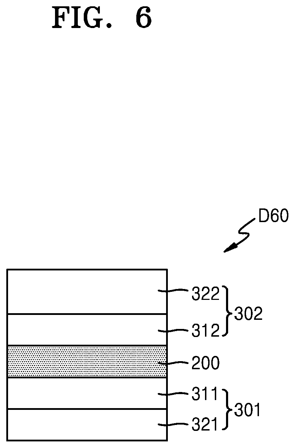

FIG. 6 is a view schematically illustrating a capacitor D60 according to some example embodiments. Referring to FIG. 6, the capacitor D60 may include a first electrode 301, a second electrode 302 which is opposite and apart from the first electrode 301, and a ferroelectric layer 200 which is arranged between the first electrode 301 and the second electrode 302. The first electrode 301 and the second electrode 302 may respectively be referred to as a lower electrode and an upper electrode, and may respectively have first electrode layers 311 and 312 and second electrode layers 321 and 322. The first electrode layers 311 and 312 may be arranged adjacent to the ferroelectric layer 200 in parallel with the ferroelectric layer 200.

The capacitor (semiconductor device) D60 of some example embodiments may be fabricated by forming an amorphous layer having the same composition as the ferroelectric layer 200 on the first electrode 301 including a semiconductor material, sequentially forming the first electrode layer 312 and the second electrode layer 322 on the amorphous layer, and simultaneously annealing the amorphous layer and the first and second electrode layers 312 and 322. During the annealing, the amorphous layer may be crystallized as the ferroelectric layer 200 owing to tensile stress between the second electrode 302 and the amorphous layer. The amorphous layer, the first electrode layer 312, and the second electrode layer 322 may be formed by a method such as at least one of atomic layer deposition (ALD), chemical vapor deposition (CVD), physical vapor deposition (PVD), or sputtering. Among the listed methods, the ALD method may enable formation of uniform layers having atom-level thicknesses at a relatively low temperature.

When the amorphous layer is formed by the ALD method, precursors may be used as a hafnium source, a zirconium source, and an oxygen source. For example, at least one selected from the group including or consisting of Hf(OtBu)₄, tetrakis ethyl methyl amino hafnium (TEMAH), tetrakis di-methyl amino hafnium (TDMAH), and tetrakis di-ethyl amino hafnium (TDEAH) may be used as a hafnium source, but embodiments are not limited thereto. In addition, at least one selected from the group including or consisting of Zr(OtBu)₄, tetrakis ethyl methyl amino zirconium (TEMAZ), tetrakis di-methyl amino zirconium (TDMAZ), and tetrakis di-ethyl amino zirconium (TDEAZ) may be used as a zirconium source, but embodiments are not limited thereto. In addition, , at least one selected from the group including or consisting of O₃, H₂O, O₂, N₂O, and O₂ plasma may be used as an oxygen source, but embodiments are not limited thereto.

The annealing may be performed under conditions for converting the amorphous layer into the ferroelectric layer 200. For example, the annealing may be performed under conditions for crystallizing the amorphous layer into an orthorhombic crystal phase. For example, the annealing may be performed at a temperature of about 400 °C to about 1100 °C, but example embodiments are not limited thereto. The annealing may be performed for a period of about 1 nano-second or more, about 1 micro-second or more, about 0.001 second or more, about 0.01 second or more, about 0.05 second or more, about 0.1 second or more, about 0.5 second or more, about 1 second or more, about 3 seconds or more, about 5 seconds or more, about 10 minutes or less, about 5 minutes or less, about 1 minute or less, or about 30 seconds or less, but example embodiments are not limited thereto. The annealing may be performed with a rapid thermal annealing (RTA) process, a fast thermal annealing (FTA) process, and/or a laser annealing process; however, example embodiments are not limited thereto.

Alternatively or additionally, when fabricating an FET, a process of forming a dielectric layer on a substrate including a semiconductor material, and a process of forming a source and a drain on the substrate including the semiconductor material may be further performed.

A capacitor may be manufactured by a method similar to a method of manufacturing the above-described FETs, except that a structure in which second electrode layers and first electrode layers are sequentially stacked is used instead of or in addition to a semiconductor substrate.

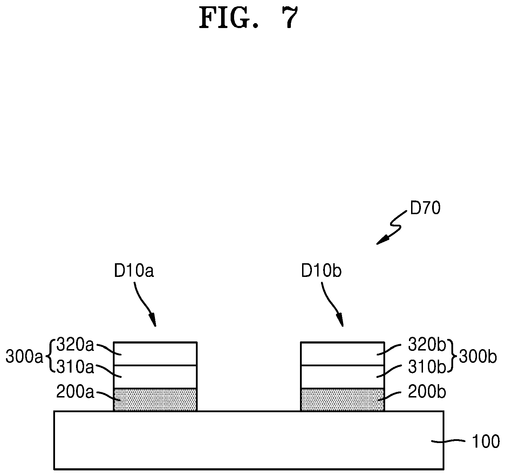

A semiconductor apparatus may include a plurality of semiconductor devices, and one or more of the semiconductor devices may include the above-described semiconductor devices (capacitors or FETs). For example, a semiconductor apparatus may include two or more of the above-described FETs, and two or more of the FETs may have different threshold voltages Vth. Referring to FIG. 7, a semiconductor apparatus D70 may include two or more FETs such as a first FET D10a and a second FET D10b which are arranged on a semiconductor substrate 100. The first and second FETs D10a and D10b may be different from each other in the compositions and/or thicknesses of first electrode layers 310a and 310b, second electrode layers 320a and 320b, and/or ferroelectric layers 200a and 200b. The first and second FETs D10a and D10b may be similar to each other in other aspects such as but not limited to channel lengths, source and drain depths and concentrations of impurities, and channel depths and concentrations of impurities. For example, the first and second FETs D10a and D10b may be different from each other in the compositions and/or thicknesses of gate electrodes 300a and 300b, but may otherwise be identical or substantially identical in other properties. For example, the first electrode layer 310a of the first FET D10a may include TiN, and the first electrode layer 310b of the second FET D10b may include tungsten (W). Alternatively or additionally, the first electrode layers 310a and 310b of the first and second FETs D10a and D10b may include TiN and may have different thicknesses. In addition, the second electrode layer 320a of the first FET D10a may include tungsten (W), and the second electrode layer 320b of the second FET D10b may include molybdenum (Mo). Alternatively or additionally, the second electrode layers 320a and 320b of the first and second FETs D10a and D10b may include molybdenum (Mo) and may have different thicknesses. In addition, the first and second FETs D10a and D10b may be different from each other in the compositions and/or thicknesses of the ferroelectric layers 200a and 200b. For example, the ferroelectric layers 200a and 200b of the first and second FETs D10a and D10b may include: a base material represented by MO₂ (where M refers to hafnium (Hf), zirconium (Zr), or a combination thereof); and different dopant materials. For example, the ferroelectric layer 200a of the first FET D10a may further include at least one dopant material selected from the group including or consisting of aluminum (Al), titanium (Ti), tantalum (Ta), scandium (Sc), and magnesium (Mg), and the ferroelectric layer 200b of the second FET D10b may further include at least one dopant material selected from the group including or consisting of lutetium (Lu), yttrium (Y), lanthanum (La), barium (Ba), and strontium (Sr).

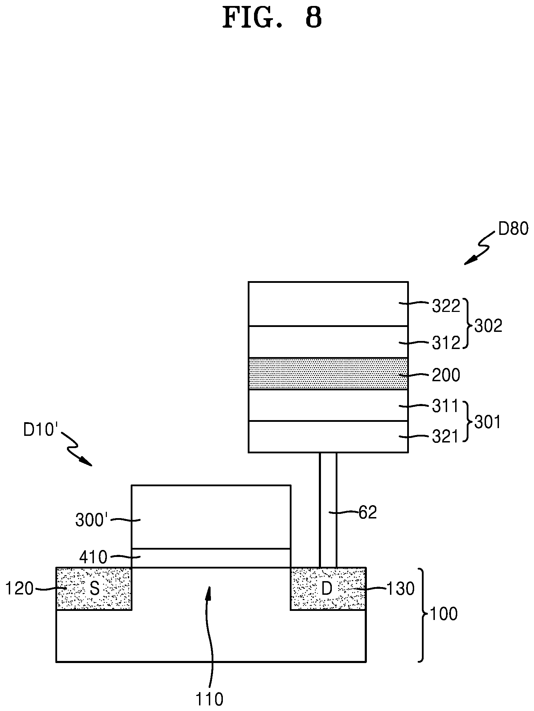

A semiconductor apparatus may include an FET and at least one active or passive electrical component, such as a capacitor which is electrically connected to the FET. The semiconductor apparatus may have memory characteristics and may be or may include, for example, a dynamic random access memory (DRAM) cell or a similar cell. FIG. 8 is a view schematically illustrating a semiconductor apparatus D80 (having a structure in which a capacitor and an FET are connected to each other) according to some example embodiments. The capacitor and/or the FET may be semiconductor devices provided according to various example embodiments. Referring to FIG. 8, the semiconductor apparatus D80 may have a structure in which a capacitor D60 and a FET D10' are electrically connected to each other through a contact 62 according to some example embodiments. For example, one of electrodes 301 and 302 of the capacitor D60 may be electrically connected to one of a source 120 and a drain 130 of the FET D10' through the contact 62. The contact 62 may include a conductive material, such as at least one of tungsten, copper, aluminum, polysilicon, or the like.

The FET D10' includes a substrate 100 including the source 120, the drain 130, and a channel 110, and a gate electrode 300' facing the channel 110. A dielectric layer 410 may be further included between the substrate 100 and the gate electrode 300'. The source 120, the drain 130, the channel 110, and the substrate 100 may be the same as those described above, and the description of the dielectric layer 400 may also be applied to the dielectric layer 410. The gate electrode 300' may include or may not include a first electrode layer 310 and a second electrode layer 320 which are as shown in FIG. 1. In addition, although the FET D10' is illustrated as not having a ferroelectric layer, the FET D10' may include a ferroelectric layer such as the ferroelectric layer 200 shown in FIG. 1.

The arrangement of the capacitor D60 and the FET D10' may be variously modified. For example, the capacitor D60 may be arranged on the substrate 100 or may be provided in the substrate 100.

Semiconductor devices and/or semiconductor apparatuses may be applied to various electronic devices. For example, the above-described FETs, capacitors, or combinations thereof may be applied as logic devices or memory devices in various electronic devices. The semiconductor devices of some example embodiments may be driven with low power and may thus be useful for miniaturization and/or integration of electronic devices. For example, the semiconductor devices and the semiconductor apparatuses of the embodiments may be used for arithmetic operations, program execution, temporary data retention, or the like in electronic devices such as mobile devices, computers, laptop computers, sensors, network devices, neuromorphic devices, and the like. The semiconductor devices and the semiconductor apparatuses of the embodiments may be used in electronic devices which continuously transmit and receive data in large amounts.

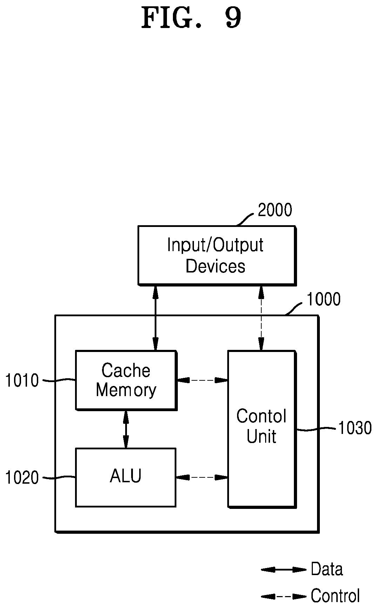

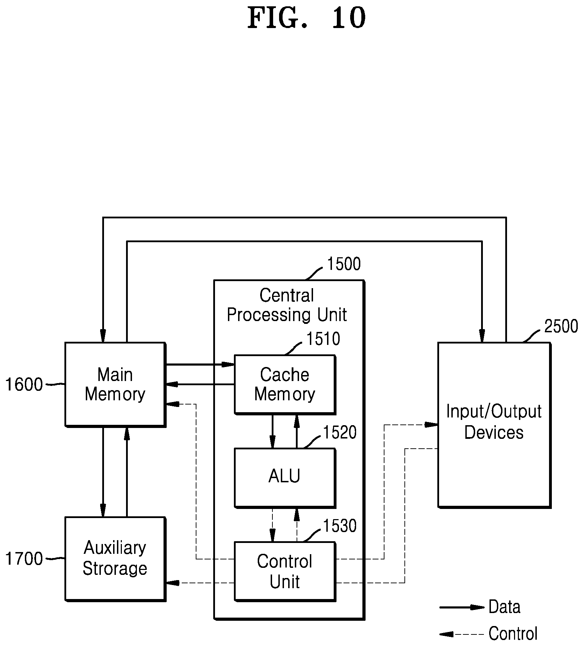

FIGS. 9 and 10 are conceptual views schematically illustrating electronic device architectures applicable to electronic devices according to embodiments.

Referring to FIG. 9, an electronic device architecture 1000 may include a memory unit 1010, an arithmetic logic unit (ALU) 1020, and a control unit 1030. The memory unit 1010, the ALU 1020, and the control unit 1030 may be electrically connected to each other. For example, the electronic device architecture 1000 may be implemented as a single chip including the memory unit 1010, the ALU 1020, and the control unit 1030. For example, the memory unit 1010, the ALU 1020, and the control unit 1030 may be connected to each other through metal lines on a chip for direct communication therebetween. The memory unit 1010, the ALU 1020, and the control unit 1030 may be monolithically integrated on a single substrate to form a single chip. Input/output devices 2000 may be connected to the electronic device architecture (chip) 1000.

The memory unit 1010, the ALU 1020, and the control unit 1030 may each independently include the above-described semiconductor devices (FETs or capacitors). For example, the ALU 1020 and the control unit 1030 may each independently include FETs such as those described above, and the memory unit 1010 may include capacitors such as those described above, FETs such as those described above, or combinations thereof. The memory unit 1010 may include a main memory and a cache memory. The electronic device architecture (chip) 1000 may be an on-chip memory processing unit.

Referring to FIG. 10, a cache memory 1510, an ALU 1520, and a control unit 1530 may form a central processing unit (CPU) 1500. The cache memory 1510 may include a static random access memory (SRAM) including FETs such as those described above. A main memory 1600 and an auxiliary storage 1700 may be provided apart from the CPU 1500. The main memory 1600 may include a dynamic random access memory (DRAM) including capacitors such as those described above.

In some cases, an electronic device architecture may be implemented in a form in which unit computing devices and unit memory devices are adjacent to each other on a single chip without sub-units.

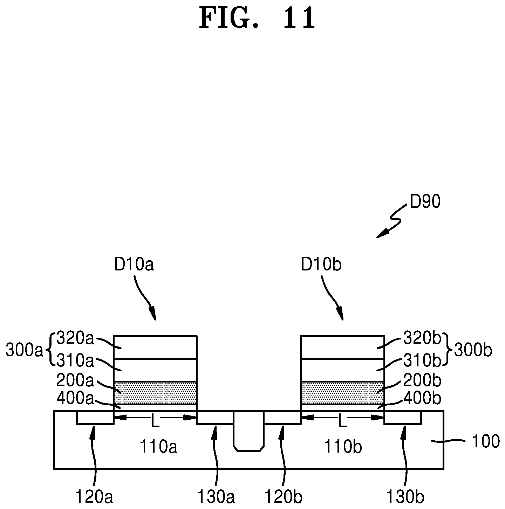

FIG. 11 is a view schematically illustrating a semiconductor apparatus according to some example embodiments.

Referring to FIG. 11, a semiconductor apparatus D90 may include first and second FETs D10a and D10b in a substrate 100. The first FET D10a may include a first source 120a, a first drain 130a, a first channel 110a, a first insulating layer 400a, a first ferroelectric layer 200a, and a first gate electrode 300a having a first electrode layer 310a and a second electrode layer 320a. The second FET D10b may include a second source 120b, a second drain 130b, a second channel 110a, a second insulating layer 400b, a second ferroelectric layer 200b, and a second gate electrode 300b having a first electrode layer 310b and a second electrode layer 320b.

The first and second FETs D10a and D10b may be different from each other in the compositions and/or thicknesses of first electrode layers 310a and 310b, second electrode layers 320a and 320b, and/or ferroelectric layers 200a and 200b. For example, the first electrode layer 310a of the first FET D10a may include TiN, and the first electrode layer 310b of the second FET D10b may include tungsten (W). Alternatively or additionally, the first electrode layers 310a and 310b of the first and second FETs D10a and D10b may include TiN and may have different thicknesses. In addition, the second electrode layer 320a of the first FET D10a may include tungsten (W), and the second electrode layer 320b of the second FET D10b may include molybdenum (Mo). Alternatively or additionally, the second electrode layers 320a and 320b of the first and second FETs D10a and D10b may include molybdenum (Mo) and may have different thicknesses. In addition, the first and second FETs D10a and D10b may be different from each other in the compositions and/or thicknesses of the ferroelectric layers 200a and 200b. For example, the ferroelectric layers 200a and 200b of the first and second FETs D10a and D10b may include: a base material represented by MO₂ (where M refers to hafnium (Hf), zirconium (Zr), or a combination thereof); and different dopant materials. For example, the ferroelectric layer 200a of the first FET D10a may further include at least one dopant material selected from the group including or consisting of aluminum (Al), titanium (Ti), tantalum (Ta), scandium (Sc), and magnesium (Mg), and the ferroelectric layer 200b of the second FET D10b may further include at least one dopant material selected from the group including or consisting of lutetium (Lu), yttrium (Y), lanthanum (La), barium (Ba), and strontium (Sr).

The first FET D10a and the second FET D10b may be adjacent to one another. There may be an isolation region 710 separating the first FET D10a and the second FET D10b.

A channel length L of the first FET D10a may be the same as a channel length L of the second FET D10b. A conductivity type of impurities in the first channel 110a may be the same as the conductivity type of impurities in the second channel 110b. Furthermore, an impurity concentration and/or a depth of the first channel 110a may be the same as a concentration and/or a depth of the second channel 110b.

Alternatively or additionally an impurity concentration and/or a junction depth of the first source 120a may be the same as the corresponding impurity concentration and/or junction depth of the second source 120b. An impurity concentration and/or a junction depth of the first drain 130a may be the same as the corresponding impurity concentration and/or junction depth of the second drain 130b. A conductivity type of impurities in the first source 120a may be the same as the corresponding conductivity type of the second source 120b. A conductivity type of impurities in the first drain 130a may be the same as the corresponding conductivity type of the second drain 130b.

For example, the physical properties of the first FET D10a and the second FET D10b may be substantially the same, apart from a material composition and/or a thickness of either or all of the first ferroelectric layer 200a, the first gate electrode 300a having electrode layers 310a and 320a, and the second ferroelectric layer 200b, and the second gate electrode 300b having electrode layers 310b and 320b. For example, a threshold voltage difference between the first FET D10a and the second FET D10b may be based on the material composition and/or the thicknesses thereof, and not based on other properties of the corresponding FETs D10a and D10b.

Hereinafter, examples of the above-described semiconductor devices will be described.

### Example 1: manufacture of a capacitor having a p-Si/SiO₂/HfZrO/TiN/Mo structure

A polysilicon (p-Si) substrate was prepared, and the surface of the polysilicon (p-Si) substrate was partially oxidized to form a silicon oxide (SiO₂) layer.

An amorphous HfZrO layer was formed on the silicon oxide (SiO₂) layer by ALD. A TiN electrode and a molybdenum (Mo) electrode were sequentially formed on the amorphous HfZrO layer by DC sputtering or ALD. The thickness of the TiN electrode was about 5 nm, and the thickness of the molybdenum (Mo) electrode was about 100 nm.

A structure formed as described above was subjected to rapid thermal annealing (RTA) at a temperature between 400 °C and 1100 °C to manufacture a capacitor including a crystallized HfZrO layer.

### Example 2: manufacture of a capacitor having a p-Si/SiO₂/La-HfZrO/TiN/Mo structure

A capacitor was manufactured in the same manner as in Example 1, except that instead of the amorphous HfZrO layer, an amorphous HfZrO layer including lanthanum (La) as a dopant material was formed on the silicon oxide (SiO₂) layer by ALD.

### Example 3: manufacture of a capacitor having a p-Si/SiO₂/HfO/TiN/Mo structure

A capacitor was manufactured in the same manner as in Example 1, except that instead of the amorphous HfZrO layer, an amorphous HfO layer was formed on the silicon oxide (SiO₂) layer by ALD.

### Example 4: manufacture of a capacitor having a Mo/TiN/HfZrO/TiN/Mo structure

A molybdenum (Mo) electrode and a TiN electrode were sequentially formed by DC sputtering or ALD.

An amorphous HfZrO layer was formed on the molybdenum (Mo) electrode by ALD. A TiN electrode and a molybdenum (Mo) electrode were sequentially formed on the amorphous HfZrO layer by DC sputtering or ALD.

A structure formed as described above was subjected to RTA at a temperature between 400 °C and 1100 °C to manufacture a capacitor including a crystallized HfZrO layer.

### Comparative Example 1: manufacture of a capacitor having a p-Si/SiO₂/ HfZrO/Mo structure

A capacitor was manufactured in the same manner as in Example 1, except that a molybdenum (Mo) electrode was formed on the amorphous HfZrO layer without forming the TiN electrode.

### Comparative Example 2: manufacture of a capacitor having a p-Si/SiO₂/La-HfZrO/Mo structure

A capacitor was manufactured in the same manner as in Example 2, except that a molybdenum (Mo) electrode was formed on the amorphous HfZrO layer including lanthanum (La) as a dopant material without forming the TiN electrode.

### Comparative Example 3: manufacture of a capacitor having a TiN/HfZrO/TiN structure

A capacitor was manufactured in the same manner as in Example 4, except that only TiN electrodes were formed without forming the molybdenum (Mo) electrodes before and after the amorphous HfZrO layer was formed.

### Electrical Characteristics 1

The polarization versus electric field hysteresis curves (P-E hysteresis curves) of the capacitors of Example 1, Example 2, Example 4, and Comparative Examples 1 and 2 were measured, and residual polarization values were measured as shown in Table 1 below. Referring to Table 1, the capacitors of Examples 1 and 2 having a two-layer electrode structure of TiN/Mo have higher residual polarization values than the capacitors of Comparative Examples 1 and 2 having a single-layer molybdenum (Mo) electrode structure. In addition, the capacitor of Example 4 having a two-layer electrode structure of TiN/Mo has a higher residual polarization value than the capacitor of Comparative Example 3 having a single-layer TiN electrode structure. From this, that the ferroelectricity of the capacitors of the examples having a two-layer electrode structure was confirmed to be substantially increased.

**[Table 1]**

| | Ferroelectric layer | Electrode | Residual polarization (µC /cm²) |
|---|---|---|---|
| Example 1 | HfZrO | TiN/Mo | 14 |
| Example 2 | La-HfZrO | TiN/Mo | 16 |
| Comparative Example 1 | HfZrO | Mo | 8.3 |
| Comparative Example 2 | La- HfZrO | Mo | 9 |
| Example 4 | HfZrO | TiN/Mo | 15 |
| Comparative Example 3 | HfZrO | TiN | 7.24 |

### Electrical Characteristics 2

Table 2 shows the planar or flat-band voltages V_{FB}, equivalent oxide thicknesses (EOTs), and leakage currents of the capacitors of Examples 1 to 3 and Comparative Example 2. Referring to Table 2, the capacitors of Examples 1 to 3 and Comparative Example 2 have different flat-band voltages V_{FB}. Since the flat-band voltage V_{FB} of a semiconductor device may be a factor that directly affects the threshold voltage Vth of the semiconductor device, various threshold voltages Vth may be obtained by varying the structures of electrodes and/or the compositions of ferroelectric layers as in Examples 1 to 3.

Alternatively or additionally, the capacitors of Examples 1 to 3 having a two-layer electrode structure of TiN/Mo had smaller EOTs and lower leakage currents than the capacitor of Comparative Example 2 having a single-layer molybdenum (Mo) electrode structure.

For reference, metal-oxide-silicon (MOS) capacitors such as the capacitors of the examples and comparative examples have a structure similar to the structure of FETs, and the performance of MOS capacitors is known to correspond to the performance of FETs.

**[Table 2]**

| | Ferroelectric layer | Electrode | Flat-band voltage (V) | EOT (nm) | Leakage current (A/cm² @1V) |
|---|---|---|---|---|---|
| Example 1 | HfZrO | TiN/Mo | 0.064 | 0.73 | 0.049 |
| Example 2 | La-HfZrO | TiN/Mo | 0.005 | 0.69 | 0.074 |
| Example 3 | HfO | TiN/Mo | 0.092 | 0.75 | 0.067 |
| Comparative Example 2 | La-HfZrO | Mo | -0.144 | 0.86 | 0.248 |

While some example embodiments have been described, the scope of example embodiments is not limited thereto, and it will be understood by those of ordinary skill in the art that various modifications and/or improvements may be made therein without departing from the scope of example embodiments as defined by the following claims.

As described above, according to the one or more of example embodiments, the semiconductor device may include a ferroelectric layer having a negative capacitance effect. The semiconductor device may have an electrode structure configured to obtain an intended threshold voltage Vth while increasing the ferroelectricity of the ferroelectric layer. The semiconductor device may have low current leakage and/or high permittivity and may be applied to various electronic devices, electronic apparatuses, electronic circuits, etc.

Any of the elements and/or functional blocks disclosed above may include or be implemented in processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc. The processing circuitry may include electrical components such as at least one of transistors, resistors, capacitors, etc. The processing circuitry may include electrical components such as logic gates including at least one of AND gates, OR gates, NAND gates, NOT gates, etc.

It should be understood that example embodiments described herein should be considered in a descriptive sense only and not for purposes of limitation. Descriptions of features or aspects within each embodiment should typically be considered as available for other similar features or aspects in other embodiments. For example, unless otherwise stated or clear from context, none of the example embodiments are necessarily mutually exclusive to one another. While one or more example embodiments have been described with reference to the figures, it will be understood by those of ordinary skill in the art that various changes in form and details may be made therein without departing from the scope as defined by the following claims.

## Claims

1. A semiconductor device (D10) comprising:
a substrate (110);
a · crystallized ferroelectric layer (200) parallel to the substrate;
a gate electrode (300) comprising a first electrode layer (310) and a second electrode layer (320);
the first electrode layer (310) apart from the substrate and on the ferroelectric layer; and
the second electrode layer (320) on the first electrode layer and spaced apart from the ferroelectric layer, and
**characterized in that** the second electrode layer has a composition different from that of the first electrode layer and a thickness greater than that of the first electrode layer, and
wherein the first electrode layer and the second electrode layer have thermal expansion coefficients less than a thermal expansion coefficient of the ferroelectric layer, and a difference between the thermal expansion coefficients of the second electrode layer and the ferroelectric layer is greater than a difference between the thermal expansion coefficients of the first electrode layer and the ferroelectric layer so that an amorphous layer having the same composition as that of the ferroelectric layer (200) is crystallized to be the ferroelectric layer (200) by a tensile stress between the amorphous layer and the gate electrode (300) during an annealing process of the semiconductor device.

2. The semiconductor device of claim 1, wherein the difference between the thermal expansion coefficients of the second electrode layer and the ferroelectric layer ranges from 3.0x10⁻⁶/K to 10.0x10⁻⁶/K.

3. The semiconductor device of claim 1 or 2, wherein the difference between the thermal expansion coefficients of the first electrode layer and the ferroelectric layer is greater than 0.0/K and less than or equal to 3.0x10⁻⁶/K.

4. The semiconductor device of any preceding claim, wherein the first electrode layer comprises at least one material selected from the group including platinum (Pt), niobium (Nb), ruthenium (Ru), molybdenum (Mo), tungsten (W), and TiN, and
the second electrode layer comprises at least one material selected from the group including platinum (Pt), niobium (Nb), ruthenium (Ru), molybdenum (Mo), tungsten (W), and TiN.

5. The semiconductor device of any preceding claim, wherein the first electrode layer comprises TiN, and the second electrode layer comprises molybdenum (Mo).

6. The semiconductor device of any preceding claim, wherein the thickness of the second electrode layer is greater than 1.0 time the thickness of the first electrode layer and is less than or equal to 30.0 times the thickness of the first electrode layer.

7. The semiconductor device of any preceding claim, wherein the thickness of the second electrode layer ranges from 10 nm to 200 nm.

8. The semiconductor device of any preceding claim, wherein the thickness of the first electrode layer ranges from 1.0 nm to 10.0 nm.

9. The semiconductor device of any preceding claim, wherein the ferroelectric layer comprises a material represented by MO₂ where M refers to hafnium (Hf), zirconium (Zr), or a combination of Hf and Zr.

10. The semiconductor device of claim 9, wherein the ferroelectric layer comprises:
a base material represented by MO₂ where M refers to hafnium (Hf), zirconium (Zr), or a combination of Hf and Zr; and
at least one dopant material selected from the group including lutetium (Lu), yttrium (Y), lanthanum (La), barium (Ba), and strontium (Sr), aluminum (Al), titanium (Ti), tantalum (Ta), scandium (Sc), and magnesium (Mg), and optionally wherein the ferroelectric layer comprises the at least one dopant material in an amount greater than 0 at% to 20 at%, the amount based on a metal element amount in the base material.

11. The semiconductor device of any preceding claim, wherein the substrate comprises a semiconductor material.

12. The semiconductor device of any preceding claim, further comprising:
a paraelectric material between the substrate and the ferroelectric layer, and optionally wherein the paraelectric material comprises a material selected from the group including aluminum oxide (Al₂O₃), lanthanum oxide (La₂O₃), yttrium oxide (Y₂O₃), and silicon oxide SiO₂.

13. A semiconductor apparatus comprising:
the semiconductor device of any preceding claim; and
at least one active or passive electrical circuitry.

14. The semiconductor apparatus of claim 13, wherein
the semiconductor device comprises at least two semiconductor devices, and
the at least two semiconductor devices have different threshold voltages.

15. The semiconductor apparatus of claim 14, wherein
the at least two semiconductor devices are different from each other in at least one of compositions of first electrode layers or thicknesses of first electrode layers,
wherein at least one of the first electrode layer, a second electrode layer, and a ferroelectric layer of one of the at least two semiconductor devices is different from a corresponding one of the first electrode layer, a second electrode layer, and a ferroelectric layer of the other of the at least two semiconductor devices in at least one of composition or thickness, and optionally wherein
one of the at least two semiconductor devices comprises a ferroelectric layer further comprising at least one dopant material selected from the group including aluminum (Al), titanium (Ti), tantalum (Ta), scandium (Sc), and magnesium (Mg), and
the other of the at least two semiconductor devices comprises a ferroelectric layer further comprising at least one dopant material selected from the group including lutetium (Lu), yttrium (Y), lanthanum (La), barium (Ba), and strontium (Sr).

## Patentansprüche

1. Halbleitervorrichtung (D10) umfassend:
ein Substrat (110);
eine kristallisierte ferroelektrische Schicht (200) parallel zu dem Substrat; eine Gate-Elektrode (300), umfassend eine erste Elektrodenschicht (310) und eine zweite Elektrodenschicht (320);
wobei die erste Elektrodenschicht (310) von dem Substrat getrennt und auf der ferroelektrischen Schicht ist; und
die zweite Elektrodenschicht (320) auf der ersten Elektrodenschicht und beabstandet von der ferroelektrischen Schicht ist, und
**dadurch gekennzeichnet, dass** die zweite Elektrodenschicht eine andere Zusammensetzung als die erste Elektrodenschicht und eine größere Stärke als die der ersten Elektrodenschicht aufweist, und
wobei die erste Elektrodenschicht und die zweite Elektrodenschicht Wärmeausdehnungskoeffizienten aufweisen, die kleiner sind als ein Wärmeausdehnungskoeffizient der ferroelektrischen Schicht, und eine Differenz zwischen den Wärmeausdehnungskoeffizienten der zweiten Elektrodenschicht und der ferroelektrischen Schicht größer ist als eine Differenz zwischen den Wärmeausdehnungskoeffizienten der ersten Elektrodenschicht und der ferroelektrischen Schicht, sodass eine amorphe Schicht, die dieselbe Zusammensetzung wie die der ferroelektrischen Schicht (200) aufweist, durch eine Zugspannung zwischen der amorphen Schicht und der Gate-Elektrode (300) während eines Temperprozesses der Halbleitervorrichtung kristallisiert, um die ferroelektrische Schicht (200) zu sein.

2. Halbleitervorrichtung nach Anspruch 1, wobei die Differenz zwischen den Wärmeausdehnungskoeffizienten der zweiten Elektrodenschicht und der ferroelektrischen Schicht in einem Bereich von 3,0x10⁻⁶/K bis 10,0x10⁻⁶/K ist.

3. Halbleitervorrichtung nach Anspruch 1 oder 2, wobei die Differenz zwischen den Wärmeausdehnungskoeffizienten der ersten Elektrodenschicht und der ferroelektrischen Schicht größer ist als 0,0/K und kleiner als oder gleich wie 3,0x10⁻⁶/K.

4. Halbleitervorrichtung nach einem der vorstehenden Ansprüche, wobei die erste Elektrodenschicht mindestens ein Material umfasst, das ausgewählt ist aus der Gruppe, die Platin (Pt), Niob (Nb), Ruthenium (Ru), Molybdän (Mo), Wolfram (W) und TiN beinhaltet, und
die zweite Elektrodenschicht mindestens ein Material umfasst, das ausgewählt ist aus der Gruppe, die Platin (Pt), Niob (Nb), Ruthenium (Ru), Molybdän (Mo), Wolfram (W) und TiN beinhaltet.

5. Halbleitervorrichtung nach einem der vorstehenden Ansprüche, wobei die erste Elektrodenschicht TiN umfasst und die zweite Elektrodenschicht Molybdän (Mo) umfasst.

6. Halbleitervorrichtung nach einem der vorstehenden Ansprüche, wobei die Stärke der zweiten Elektrodenschicht größer ist als das 1,0-fache der Stärke der ersten Elektrodenschicht und kleiner als oder gleich wie das 30,0-fache der Stärke der ersten Elektrodenschicht.

7. Halbleitervorrichtung nach einem der vorstehenden Ansprüche, wobei die Stärke der zweiten Elektrodenschicht in einem Bereich von 10 nm bis 200 nm ist.

8. Halbleitervorrichtung nach einem der vorstehenden Ansprüche, wobei die Stärke der ersten Elektrodenschicht in einem Bereich von 1,0 nm bis 10,0 nm ist.

9. Halbleitervorrichtung nach einem der vorstehenden Ansprüche, wobei die ferroelektrische Schicht ein Material umfasst, das dargestellt ist durch MO₂, wobei sich M auf Hafnium (Hf), Zirkonium (Zr) oder eine Kombination aus Hf und Zr bezieht.

10. Halbleitervorrichtung nach Anspruch 9, wobei die ferroelektrische Schicht Folgendes umfasst:
ein Grundmaterial, dargestellt durch MO₂, wobei sich M auf Hafnium (Hf), Zirkonium (Zr) oder eine Kombination aus Hf und Zr bezieht; und
mindestens ein Dotiermaterial, das ausgewählt ist aus der Gruppe, die Lutetium (Lu), Yttrium (Y), Lanthan (La), Barium (Ba) und Strontium (Sr), Aluminium (Al), Titan (Ti), Tantal (Ta), Scandium (Sc) und Magnesium (Mg) beinhaltet, und optional wobei die ferroelektrische Schicht das mindestens eine Dotiermaterial in einer Menge von mehr als 0 At-% bis 20 At-% umfasst, wobei die Menge auf einer Metallelementmenge in dem Grundmaterial basiert.

11. Halbleitervorrichtung nach einem der vorstehenden Ansprüche, wobei das Substrat ein Halbleitermaterial umfasst.

12. Halbleitervorrichtung nach einem der vorstehenden Ansprüche, ferner umfassend:
ein paraelektrisches Material zwischen dem Substrat und der ferroelektrischen Schicht, und optional wobei das paraelektrische Material ein Material umfasst, das ausgewählt ist aus der Gruppe, die Aluminiumoxid (Al₂O₃), Lanthanoxid (La₂O₃), Yttriumoxid (Y₂O₃) und Siliziumoxid SiO₂ beinhaltet.

13. Halbleitervorrichtung, umfassend:
die Halbleitervorrichtung nach einem der vorstehenden Ansprüche; und
mindestens eine aktive oder passive elektrische Schaltung.

14. Halbleitervorrichtung nach Anspruch 13, wobei
die Halbleitervorrichtung mindestens zwei Halbleitervorrichtungen umfasst und
die mindestens zwei Halbleitervorrichtungen unterschiedliche Schwellenwertspannungen aufweisen.

15. Halbleitervorrichtung nach Anspruch 14, wobei
die sich mindestens zwei Halbleitervorrichtungen in mindestens einem von den Zusammensetzungen der ersten Elektrodenschichten oder der Stärken der ersten Elektrodenschichten voneinander unterscheiden,
wobei sich mindestens eine von der ersten Elektrodenschicht, einer zweiten Elektrodenschicht und einer ferroelektrischen Schicht einer der mindestens zwei Halbleitervorrichtungen in mindestens einem von der Zusammensetzung oder Stärke von einer entsprechenden der ersten Elektrodenschicht, einer zweiten Elektrodenschicht und einer ferroelektrischen Schicht der anderen der mindestens zwei Halbleitervorrichtungen unterscheidet, und optional wobei
eine der mindestens zwei Halbleitervorrichtungen eine ferroelektrische Schicht umfasst, ferner umfassend mindestens ein Dotiermaterial, das ausgewählt ist aus der Gruppe, die Aluminium (Al), Titan (Ti), Tantal (Ta), Scandium (Sc) und Magnesium (Mg) beinhaltet, und
die andere der mindestens zwei Halbleitervorrichtungen eine ferroelektrische Schicht umfasst, ferner umfassend mindestens ein Dotiermaterial, das ausgewählt ist aus der Gruppe, die Lutetium (Lu), Yttrium (Y), Lanthan (La), Barium (Ba) und Strontium (Sr) beinhaltet.

## Revendications

1. Dispositif à semi-conducteur (D10) comprenant :
un substrat (110) ;
une couche ferroélectrique cristallisée (200) parallèle au substrat ;
une électrode de grille (300) comprenant une première couche d'électrode (310) et une seconde couche d'électrode (320) ;
la première couche d'électrode (310) à l'écart du substrat et sur la couche ferroélectrique ; et
la seconde couche d'électrode (320) sur la première couche d'électrode et espacée de la couche ferroélectrique, et
**caractérisé en ce que** la seconde couche d'électrode a une composition différente de celle de la première couche d'électrode et une épaisseur supérieure à celle de la première couche d'électrode, et
dans lequel la première couche d'électrode et la seconde couche d'électrode ont des coefficients de dilatation thermique inférieurs à un coefficient de dilatation thermique de la couche ferroélectrique, et une différence entre les coefficients de dilatation thermique de la seconde couche d'électrode et de la couche ferroélectrique est supérieure à une différence entre les coefficients de dilatation thermique de la première couche d'électrode et de la couche ferroélectrique de sorte qu'une couche amorphe ayant la même composition que celle de la couche ferroélectrique (200) est cristallisée pour être la couche ferroélectrique (200) par une contrainte de traction entre la couche amorphe et l'électrode de grille (300) pendant un processus de recuit du dispositif à semi-conducteur.

2. Dispositif à semi-conducteur selon la revendication 1, dans lequel la différence entre les coefficients de dilatation thermique de la seconde couche d'électrode et de la couche ferroélectrique est comprise entre 3,0 x 10⁻⁶/K et 10,0 x 10⁻⁶/K.

3. Dispositif à semi-conducteur selon la revendication 1 ou 2, dans lequel la différence entre les coefficients de dilatation thermique de la première couche d'électrode et de la couche ferroélectrique est supérieure à 0,0/K et inférieure ou égale à 3,0 x 10⁻⁶/K.

4. Dispositif à semi-conducteur selon l'une quelconque des revendications précédentes, dans lequel la première couche d'électrode comprend au moins un matériau choisi dans le groupe comprenant le platine (Pt), le niobium (Nb), le ruthénium (Ru), le molybdène (Mo), le tungstène (W) et le TiN, et
la seconde couche d'électrode comprend au moins un matériau choisi dans le groupe comprenant le platine (Pt), le niobium (Nb), le ruthénium (Ru), le molybdène (Mo), le tungstène (W) et le TiN.

5. Dispositif à semi-conducteur selon l'une quelconque des revendications précédentes, dans lequel la première couche d'électrode comprend du TiN, et la seconde couche d'électrode comprend du molybdène (Mo).

6. Dispositif à semi-conducteur selon l'une quelconque des revendications précédentes, dans lequel l'épaisseur de la seconde couche d'électrode est supérieure à 1,0 fois l'épaisseur de la première couche d'électrode et est inférieure ou égale à 30,0 fois l'épaisseur de la première couche d'électrode.

7. Dispositif à semi-conducteur selon l'une quelconque des revendications précédentes, dans lequel l'épaisseur de la seconde couche d'électrode est comprise entre 10 nm et 200 nm.

8. Dispositif à semi-conducteur selon l'une quelconque des revendications précédentes, dans lequel l'épaisseur de la première couche d'électrode est comprise entre 1,0 nm et 10,0 nm.

9. Dispositif à semi-conducteur selon l'une quelconque des revendications précédentes, dans lequel la couche ferroélectrique comprend un matériau représenté par MO₂ où M fait référence à l'hafnium (Hf), au zirconium (Zr) ou à une combinaison de Hf et de Zr.

10. Dispositif à semi-conducteur selon la revendication 9, dans lequel la couche ferroélectrique comprend :
un matériau de base représenté par MO₂ où M fait référence à l'hafnium (Hf), au zirconium (Zr), ou à une combinaison de Hf et Zr ; et
au moins un matériau dopant choisi dans le groupe comprenant le lutétium (Lu), l'yttrium (Y), le lanthanum (La), le baryum (Ba) et le strontium (Sr), l'aluminium (Al), le titane (Ti), le tantale (Ta), le scandium (Sc) et le magnésium (Mg), et éventuellement dans lequel la couche ferroélectrique comprend l'au moins un matériau dopant en une quantité supérieure à 0 at% à 20 at%, la quantité étant basée sur une quantité d'élément métallique dans le matériau de base.

11. Dispositif à semi-conducteur selon l'une quelconque des revendications précédentes, dans lequel le substrat comprend un matériau semi-conducteur.

12. Dispositif à semi-conducteur selon l'une quelconque des revendications précédentes, comprenant en outre :
un matériau paraélectrique entre le substrat et la couche ferroélectrique, et éventuellement dans lequel le matériau paraélectrique comprend un matériau choisi dans le groupe comprenant l'oxyde d'aluminium (Al₂O₃), l'oxyde de lanthane (La₂O₃), l'oxyde d'yttrium (Y₂O₃) et l'oxyde de silicium SiO₂.

13. Appareil à semi-conducteur comprenant :
le dispositif à semi-conducteur selon l'une quelconque des revendications précédentes ; et
au moins un circuit électrique actif ou passif.

14. Appareil à semi-conducteur selon la revendication 13, dans lequel
le dispositif à semi-conducteur comprend au moins deux dispositifs à semi-conducteur, et
les au moins deux dispositifs à semi-conducteur ont des tensions de seuil différentes.

15. Appareil à semi-conducteur selon la revendication 14, dans lequel
les au moins deux dispositifs à semi-conducteur diffèrent l'un de l'autre par au moins l'une des compositions de premières couches d'électrode ou des épaisseurs de premières couches d'électrode,
dans lequel au moins l'une de la première couche d'électrode, d'une seconde couche d'électrode et d'une couche ferroélectrique de l'un des au moins deux dispositifs à semi-conducteur est différente de l'une correspondante de la première couche d'électrode, d'une seconde couche d'électrode et d'une couche ferroélectrique de l'autre des au moins deux dispositifs à semi-conducteur dans au moins l'une de la composition ou de l'épaisseur, et éventuellement dans lequel
l'un des au moins deux dispositifs à semi-conducteur comprend une couche ferroélectrique comprenant en outre au moins un matériau dopant choisi dans le groupe comprenant l'aluminium (Al), le titane (Ti), le tantale (Ta), le scandium (Sc) et le magnésium (Mg), et
l'autre des au moins deux dispositifs à semi-conducteur comprend une couche ferroélectrique comprenant en outre au moins un matériau dopant choisi dans le groupe comprenant le lutétium (Lu), l'yttrium (Y), le lanthanum (La), le baryum (Ba) et le strontium (Sr).
